# EUROPEAN PATENT SPECIFICATION

(11) **EP 2 112 487 B1**
(45) Date of publication and mention of the grant of the patent: **27.07.2016**
(21) Application number: 08007821.5
(22) Date of filing: 23.04.2008
(51) Int. Cl.: G01L 9/00

(54) **Method for manufacturing a pressure sensor by applying a cover layer**
Verfahren zum Herstellen eines Drucksensors durch Aufbringen einer Deckschicht
Procédé de fabrication d'un capteur de pression en appliquant une couche de fermeture

(43) Date of publication of application: 28.10.2009
(73) Proprietor: Sensirion AG, 8712 Stäfa (CH)
(72) Inventor: Bühler, Johannes, CH-8610 Uster (CH); Mayer, Felix, CH-8712 Stäfa (CH); Hornung, Mark, CH-8708 Männedorf (CH); Hunziker, Werner, CH-8712 Stäfa (CH); Sunier, Robert, CH-8046 Zürich (CH)
(74) Representative: Sutter, Kurt

(56) References cited:
- EP-A- 1 860 417
- DE-A1- 4 207 951
- DE-A1- 10 062 637

## Description

The invention relates to a method for manufacturing a pressure sensor based on a semiconductor chip with a pressure sensitive membrane. The semiconductor chip in mounted in a housing.

This type of method is e.g. described in US 6 229 190, WO 2006/114005 or EP 1 717 562.

The problem to be solved by the present invention is to provide a method of the type above that allows a simple manufacturing process.

This object is solved by the sensor and method according to the independent claims. Accordingly, a semiconductor chip is provided, which already carries or is later processed to carry a pressure sensitive membrane. Furthermore, the semiconductor chip carries a topmost dielectric layer of silicon oxide and/or silicon nitride. Such a layer is e.g. typically applied as a topmost layer in a standard CMOS manufacturing process. A cover layer is then applied to the topmost dielectric layer. This cover layer comprises a material different from the topmost dielectric layer in order to allow to optimize it to provide a good sealing connection with the connecting member mentioned below. The cover layer forms a port that provides access therethrough to said membrane. Now, the chip with the cover layer is mounted partially or fully in a housing having a connecting member. The connecting member forms a connecting duct to allow access for a fluid whose pressure is to be measured. The connecting member is positioned to form a sealed connection between the connecting duct and at least one of the ports.

This process can be carried out easily since it allows a large number of steps to be implemented in standard chip manufacturing technology (such as a standard CMOS manufacturing process), and the cover layer can be especially designed to provide the sealing connection as described and/or to fulfill one or more of the following requirements:
distribute the strain caused by the connecting member, provide sufficiently large surface for a tight seal without increasing the costly chip size,
utilize commonly available, low cost sealing techniques such as a squeezed rubber seal or glueing, accommodate the fabrication tolerances of such techniques.

Advantageously, the cover layer is softer than the topmost dielectric layer, thus providing an improved seal.

Further advantageous embodiments of the present invention are described in the dependent claims as well as in the following description and the attached figures. The figures show:
Fig. 1 is a sectional view through a pressure sensor with part of the surrounding housing structure, Fig. 2 is a top view of the sensor of Fig. 1,
Fig. 3 is a sectional view of a second embodiment of a pressure sensor,
Fig. 4 is a sectional view of a third embodiment of a pressure sensor,
Fig. 5 is a sectional view of a pressure sensor in its housing,
Fig. 6 a legend of the hatching styles used in all the figures,
Fig. 7 a sectional view of a second embodiment of a housing assembly,
Fig. 8 a sectional view of a third embodiment of a housing assembly,
Fig. 9 a sectional view of a fourth embodiment of a housing assembly, and
Fig. 10 a sectional view of a fifth embodiment of a housing assembly.

### Definitions:

The vertical direction and location designators "top" and "bottom" are to be understood such that the direction top-bottom corresponds to the direction from the cover layer to the substrate of the semiconductor chip. The designations "up" and "down", "above" and "below" are to be understood in analogous manner, e.g. the cover layer is above the semiconductor chip.

A "pressure sensor" is to be understood to encompass any sensor measuring a pressure or a parameter depending on the pressure due to deformation of the membrane. In particular, the term comprises sensors for measuring absolute or differential pressure, static or dynamic pressure (including sound), even though the invention is most advantageously applied for differential pressure sensors.

A "Silicon-on-insulator" wafer or "SOI" wafer is a wafer comprising a silicon substrate, an insulator layer arranged on the silicon substrate as well as a silicon layer arranged on the insulator layer.

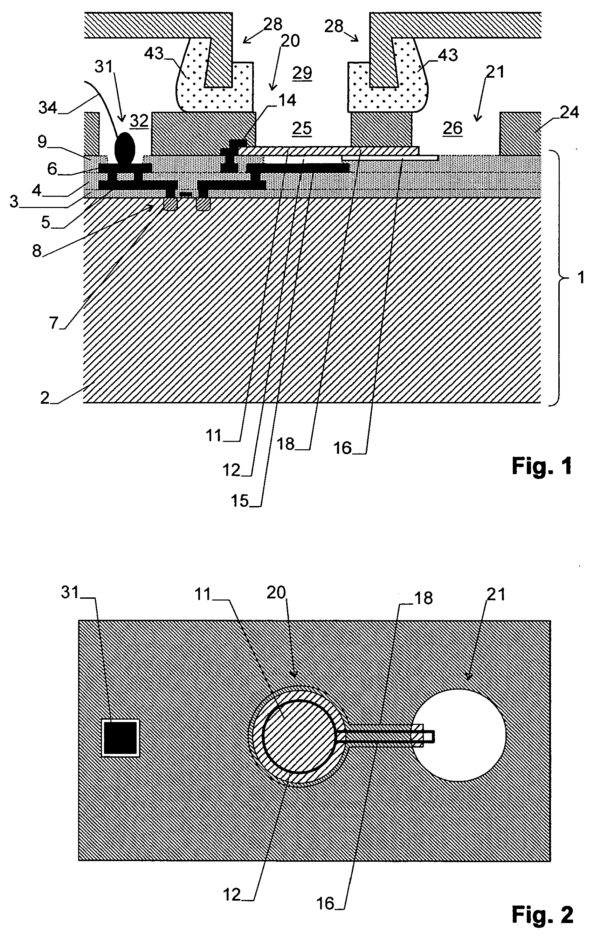

A first example of a pressure sensor is described with reference to Figs. 1 and 2. The sensor comprises a semiconductor chip generally denoted by 1. The semiconductor chip has a silicon substrate 2, at the top surface of which various layers and structures as generally known from CMOS manufacturing processes have already been applied. The layers and structures comprise, for example, a plurality of SiO₂ layers 3, 4 and metal or polysilicon layers 5, 6 as well as doped regions 7 within the silicon. These components can e.g. form active circuitry 8, such as used in amplifiers or for other analog and/or digital signal processing. The semiconductor chip has a topmost dielectric layer 9 of silicon oxide and/or silicon nitride protecting the structures below it.

Further, a pressure sensitive membrane 11 is applied over the silicon chip. In the embodiment of Fig. 1, membrane 11 is formed by a doped, conducting silicon layer. Membrane 11 is sufficiently thin such that it deforms depending on the pressure drop applied over it. The deformation is sufficient to allow a measurement of this pressure drop. Membrane 11 is arranged as a sealing lid over a cavity 12.

In the embodiment of Fig. 1, membrane 11 forms a first electrode at the top side of cavity 12 and is connected via suitable metal leads 14 to the circuitry of semiconductor chip 1. A second electrode 15 is arranged at the bottom side of cavity 12 and is also connected to the circuitry of semiconductor chip 1. Depending on the pressure drop over membrane 11, the electrical capacitance between membrane 11 and electrode 15 will vary, thereby allowing the pressure drop (or any quantity dependent thereon) to be measured.

Membrane 11 is formed by a membrane layer 18. Membrane layer 18 can e.g. a single or multiple layer structure of silicon and/or silicon oxide and/or silicon nitride. In a preferred embodiment it is of silicon and can e.g. be manufactured as described in the document EP 1 860 417, which provides additional information about sensors of the type described here.

It must be noted, however, that the present invention is not limited to capacitive pressure sensors. Rather, it can be used with any type of pressure sensors that uses a deformable membrane in order to measure a quantity dependent on the pressure drop over the same. In particular, the invention can also be used for sensors where the deformation of the membrane is measured by piezoresistive means.

The sensor of Figs. 1 and 2 is a differential pressure sensor adapted to measure the difference of two pressures. A first pressure is applied at a first port 20 to the top side of membrane 11, a second pressure to the bottom side thereof. To apply the second pressure, cavity 12 is accessible through a channel 16, which is also schematically shown in Fig. 2. Channel 16 extends below membrane layer 18 and connects cavity 12 to a second port 21 at the top side of semiconductor chip 1.

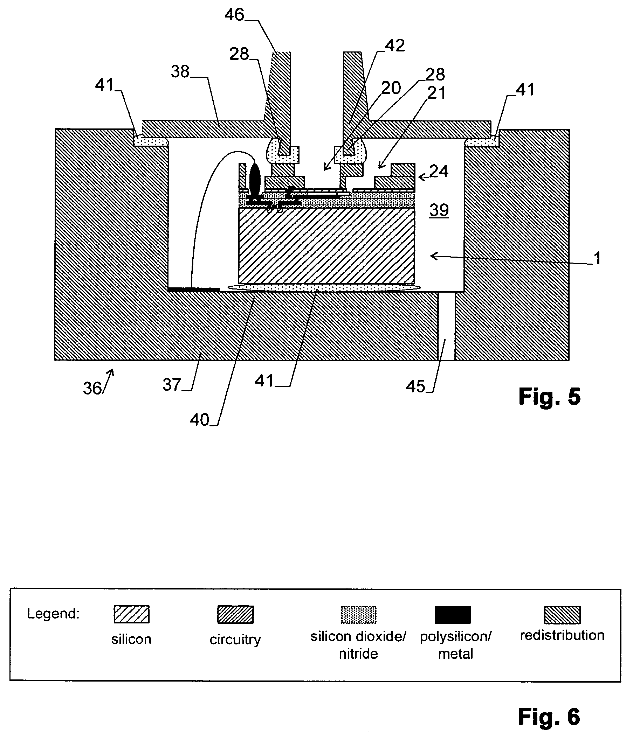

A cover layer 24 (called "redistribution" in the legend of Fig. 6) is applied over topmost dielectric layer 9 and membrane layer 18. A first opening 25 in cover layer 24 arranged over membrane 11 forms the first port 20, and another opening 26 in cover layer 24 forms the second port 21.

The two ports 20, 21 must be connected to the fluid(s) whose pressure (differential) is to be measured. For this purpose, the sensor is packaged in a housing. A suitable housing comprises a connecting member 28, which forms a connecting duct 29. Connecting member 28 is formed as a solid part, e.g. in a moulding process with subsequent solidification, prior to being brought into contact with cover layer 24. Advantageously, connecting member 28 is pushed against cover layer 24 from above and abuts against the same, thereby forming a sealed connection between first port 20 and connecting duct 29 of connecting member 28.

Second port 21 can be connected to a fluid under a second pressure, e.g. as described in reference to Fig. 5 below.

Cover layer 24 can be designed to optimize the connection to connecting member 28. For example, in order to provide a good connection between connecting member 28 and first port 20, cover layer 24 is advantageously made of a material that is softer than topmost dielectric layer 9. It can e.g. be a polymer, such as a silicone or a carbon-based polymer. For reasons that will become apparent below, it is advantageously formed by one or more layers of photoresist.

Alternatively, cover layer 24 can be formed by a silicon layer, such as the silicon substrate of an SOI wafer. A suitable method for manufacturing and structuring a cover layer 24 of silicon from an SOI-wafer is described in EP 1 860 417 mentioned above: cover layer 24 of the present invention can be formed by applying an SOI-wafer to the top of semiconductor chip 1 and structuring the SOI-wafer. Hence, cover layer 24 of the present invention would be formed by silicon substrate 15 of EP 1 860 417. The description of the corresponding manufacturing steps and device design of EP 1 860 417 is incorporated by reference herein.

In the following, the steps for manufacturing the sensor of Figs. 1 and 2 are described. The same steps can, basically, also be applied to the sensors according to the other embodiments of the present invention, as they will be described below.

In a first step, semiconductor chip 1 with substrate 2 and with the layers and structures 3 - 9 is manufactured e.g. using known CMOS processing techniques. As shown in Figs. 1 and 2, in addition to the structures described above, this can also encompass the formation of further elements, such as contact pads 31.

At the same time, a groove is formed at the location of later channel 16 in topmost dielectric layer 9, and topmost dielectric layer 9 is removed at the locations of later cavity 12 and contact window 31.

Now, membrane 11 is formed, e.g. by using the steps described in EP 1 860 417, the description of which is incorporated by reference herein. It must be noted that membrane 11 of the present invention corresponds to silicon layer 17 of EP 1 860 417. In this process, an SOI-wafer having a silicon substrate, an intermediate insulator layer and a covering silicon layer is applied to the top of topmost dielectric layer 9 with the covering silicon layer facing downwards. Then the silicon substrate of the SOI-wafer as well as (optionally) the insulating layer are removed by etching, leaving only said covering silicon layer as membrane layer 18. Membrane layer 18 can then be structured using photolitographic steps as known to the person skilled in the art and as described in EP 1 860 417.

Applying membrane 11 in this matter also forms channel 16 and cavity 12 below membrane layer 18.

Now, the metal leads 14 are manufactured for electrically connecting membrane 11 to the circuitry on silicon chip 1.

In a next step, cover layer 24 is applied. In a particularly advantageous embodiment, this is achieved by applying a "dry film photoresist", which will finally form cover layer 24. For example, SU-8 photoresist film can be used. The SU-8 photoresist is a negative, epoxy-type, near-UV photoresist well known to the person skilled in the art and dry films of it are e.g. manufactured under the name of WBR2000 by Dupont in Washington WA, USA. The photoresist film is structured by applying a second dry or wet photoresist, using standard photolithographic structuring and subsequent plasma etching, leaving only those regions of the photoresist film which will form cover layer 24. Structuring cover layer 24 forms the ports 20, 21 as well as windows 32 for the contact pads 31.

Using one or more dry film photoresists for forming cover layer 24 has the advantage that dry films do not tend to block channels formed in the layers below them.

Advantageously, cover layer 24 has a thickness of at least 10 µm in order to distribute the stress caused by connecting the sensor to connecting member 28 and to accommodate the deformation caused by the same. Deposition and structuring of the cover layer 24 may be done in several passes to achieve the desired thickness. The thickness does advantageously not exceed 100 µm since much thicker layers are unnecessary, difficult to form and to structure, prolong processing times and may be too easily deformed, thereby potentially blocking the ports 20, 21.

It must be noted, though, that thicker cover layers may be used. Thick cover layers can advantageously be manufactured by applying several identically structured sublayers on top of each other.

Now, and as described above, the device can be mounted in its housing. For this purpose and as mentioned above, connecting member 28 is pushed from above against the region of cover layer 24 that surrounds port 20. At the same time, silicon chip 1 can rest against a backrest section of the same housing, thereby compressing semiconductor chip 1 and cover layer 24 between connecting member 28 and the backrest section, which allows to push connecting member 28 against cover layer 24. This arrangement will be illustrated in respect to a another embodiment with reference to Fig. 5 below.

Advantageously prior to applying connecting member 28, bond wires 34, as schematically illustrated in Fig. 1, are applied to the contact pads 31 and connected to metal leads arranged in the housing.

In the embodiment of Figs. 1 and 2, membrane layer 18 forms an intermediary layer between part of topmost dielectric layer 9 and cover layer 24. It is, however, not arranged everywhere between topmost dielectric layer 9 and cover layer 24. The advantage of this design is that capacitive couplings between the (conducting) membrane layer 18 and the circuitry on semiconductor chip 1 can be kept at a minimum. However, this design may cause a certain degree of unevenness at the top side of cover layer 24.

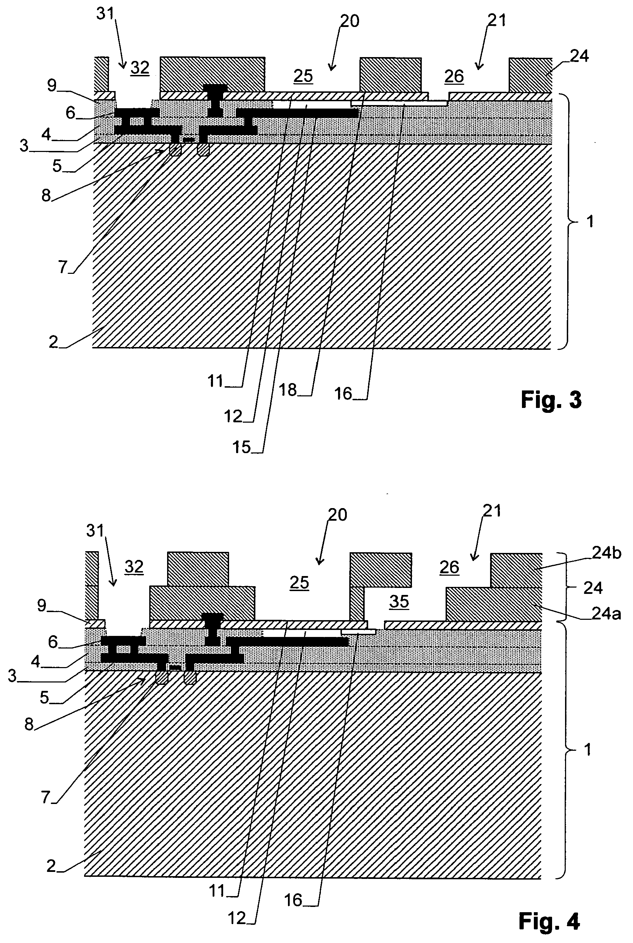

Therefore, in a second embodiment, as shown in Fig. 3, all of cover layer 24 is arranged over intermediate layer or membrane layer 18. This has the advantage that the top side of cover layer 24 is more even than in the embodiment of Figs. 1 and 2.

In the embodiments shown so far, a channel 16 of a length substantially corresponding to the distance between the rims of the two ports 20, 21 is arranged in the topmost dielectric layer 9. A more compact design is shown in Fig. 4. Here, channel 16 is much shorter and connected to a further channel section 35 in cover layer 24. Channel section 35 extends "horizontally", e.g. parallel to the surface of semiconductor chip 1. This allows to reduce the die area of the individual sensors and thereby saving cost.

To incorporate channel section 35, cover layer 24 is manufactured from at least a first sublayer 24a and a second sublayer 24b. In a first step, first sublayer 24a is applied to semiconductor chip 1 and is structured with a first pattern. The first pattern is designed to create an opening at the location of later channel section 35 as well as at the locations of the ports 20, 21 and the contact pad 31. Then, second sublayer 24b is applied over first sublayer 24a. Advantageously, at least second sublayer 24b is applied as a so called "dry film photoresist", which allows to bridge the openings previously formed in first sublayer 24a. Second sublayer 24b is photolithographically structured with a second pattern that is different from the first pattern. In particular, the second pattern is designed such that it covers the top of channel section 35, while openings are formed at the locations of the ports 20, 21 and the contact pad 31.

Alternatively, cover layer 24 or one or both sublayers 24a, 24b can be manufactured by screen printing techniques, with the ink being e.g. a silicone paste or a resin that is cured after printing. One advantage of screen printing lies in the fact that the applied ink can be prevented from blocking channels in lower layers by suitably masking the screen.

As mentioned, the device of Figs. 1 - 4 is arranged in a housing that provides a sealed connection to the ports 20, 21. "Sealing" in this context is understood to provide at least a sufficient sealing between the two ports such that the desired measurement is not impaired by leak flows of fluid between the ports.

A suitable housing is shown in Fig. 5. As can be seen, the housing 36 comprises a bottom section 37 and a top section 38. Bottom section 37 is e.g. substantially bowl-shaped and forms the bottom and side walls of a chamber 39 for receiving the actual sensor chip. The part of bottom section 37 forming the bottom of chamber 39 is termed backrest section 40. The bottom of semiconductor chip 1 rests against an elastic glue cushion 41, e.g. of silicone, which reduces strain in the chip.

The top section 38 of housing 36 forms a lid for chamber 39 and hermetically seals the same by means of a circumferential sealing 41. Connecting member 28 is formed by the bottom end of a tube 42 extending through top section 38 and is coated by a soft, elastic lip 43, e.g. of silicone, which avoids unnecessary strain on cover layer. Tube 42 ends in a connector flange 46 at the outer side of top section 38. Connector flange 46 serves to attach the device e.g. by means of a tube or an o-ring to an external system.

As can be seen, port 20 is connected to the connecting duct of connecting member 28, while port 21 is connected to chamber 39. Chamber 39 is, in turn, advantageously provided with an exit opening 45 arranged at the side of the housing 36 opposite to the ports 20, 21.

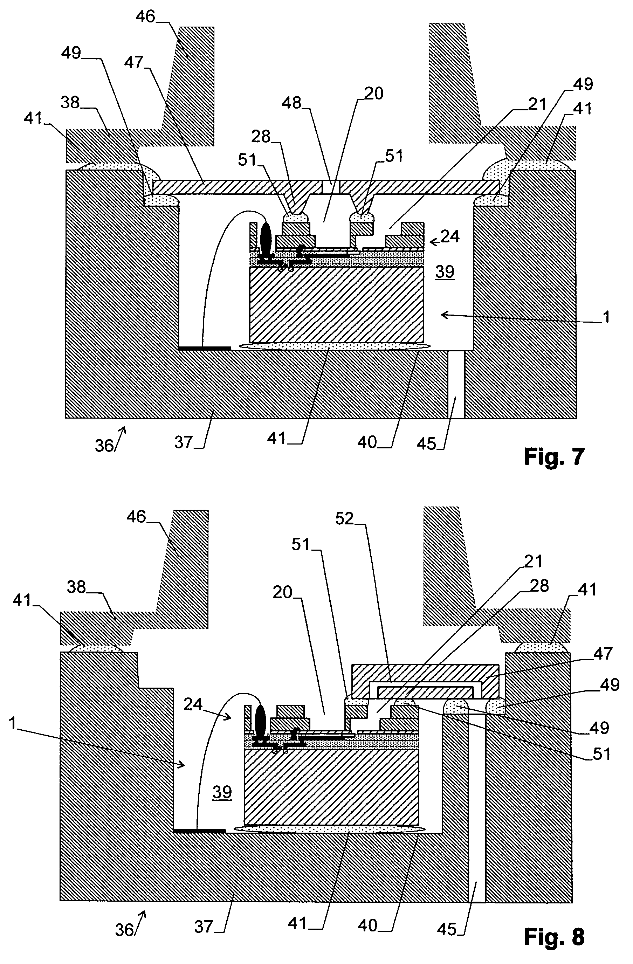

Another embodiment of a housing assembly is shown in Fig. 7. This design differs from the one of Fig. 5 in that connecting member 28 is not formed by top section 38 of housing 36, but rather by an auxiliary member 47. Auxiliary member 47 is arranged at a distance from top section 38 below the same. Auxiliary member 47 is substantially plate shaped, extends through chamber 39 and comprises an opening 48 to provide a passage between port 20 and flange 46. It is glued to bottom housing section 37 by means of a resilient glue 49, such as silicone. This design has the advantage that forces exerted to flange 46 are not directly transmitted to semiconductor chip 1 because connecting member 28 is part of the resiliently mounted auxiliary member 47 and not directly connected to top housing section 38.

The embodiment of Fig. 7 also differs from the one of Fig. 5 in that connecting member 28 does not actively push against cover layer 24 but rather is connected to the same by means of a ring 51 of resilient glue. Ring 51 is arranged around port 20.

A third embodiment of a housing assembly is shown in Fig. 8. It differs from the one of Fig. 7 in that connecting member 28 of auxiliary member 47 does not contact port 20, but rather port 21. Ring 51 is arranged around port 21. A duct 52 within auxiliary member 47 connects port 21 to exit opening 45, while port 20 communicates with flange 46 through chamber 39.

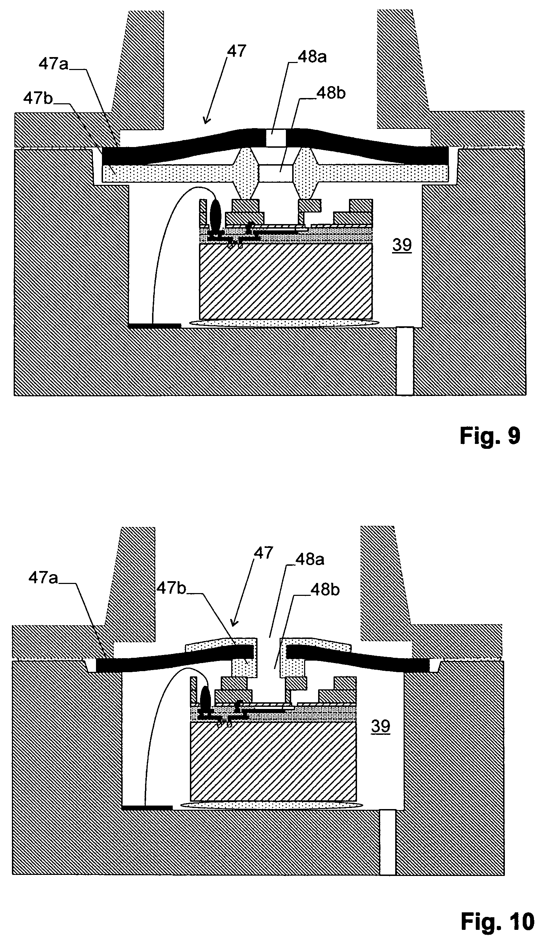

A fourth embodiment of a housing assembly is shown in Fig. 9. It differs from the one of Fig. 7 in that auxiliary member 47 is formed by the combination of an elastic lid 47a and a sealing member 47b. Both, elastic lid 47a and sealing member 47b extend over chamber 39 and are elastically deformable, but sealing member 47b is softer than elastic lid 47a. Elastic lid 47a is biased to push sealing member 47b against port 20 and/or 21, thereby forming a sealing connection. Elastic lid 47a can e.g. be a steel spring plate, while sealing member 47b can be of silicone or rubber. Openings 48a, 48b, in elastic lid 47a and sealing member 47b, provide a passage between port 20 and flange 46.

Yet a further embodiment is shown in Fig. 10. This embodiment differs from the one of Fig. 9 in that sealing member 47b does not extend over all of chamber 39, but only over part of it. Sealing member 47b is advantageously of rubber vulcanized to elastic member 47a.

## Claims

1. A method for manufacturing a pressure sensor comprising
providing a semiconductor chip (1) for carrying a pressure sensitive membrane (11) and having a topmost dielectric layer (9) of silicon oxide and/or silicon nitride,
**characterized in** the steps of
applying a cover layer (24) over said topmost dielectric layer (9), wherein said cover layer (24) comprises a material different from said topmost dielectric layer (9) and forms at least one port (20) providing access to said membrane (11),
mounting said chip with said cover layer (24) in a housing (36) having a connecting member (28), wherein said connecting member (28) forms a connecting duct (29) and
forming a sealed connection between said connecting duct (29) and said port (20).

2. The method of claim 1 wherein said cover layer (24) is softer than said topmost dielectric layer (9) .

3. The method of any of the preceding claims wherein said cover layer (24) is of a polymer, in particular a silicone or a photoresist.

4. The method of claim 1 wherein said cover layer (24) comprises a silicon layer, and in particular wherein said method further comprises the step of manufacturing said cover layer (24) by applying an SOI-wafer to said semiconductor chip (1) and structuring said SOI-wafer.

5. The method of any of the preceding claims comprising the step of structuring said cover layer (24) after applying said cover layer (24).

6. The method of any of the preceding claims wherein said cover layer (24) comprises a first sublayer (24a) and a second sublayer (24b) and said method comprises the steps of
applying the first sublayer (24a) and structuring the first sublayer (24a) with a first pattern and
applying the second sublayer (24b) over said first sublayer (24a) and structuring the second sublayer (24b) with a second pattern different from said first pattern, such that said port (20) is connected to a channel section (35) parallel to a surface of said semiconductor chip (1) in said first sublayer (24a).

7. The method of any of the preceding claims comprising the step of using photoresist for forming said cover layer (24), in particular by using at least one dry film photoresist layer for forming said cover layer (24).

8. The method of any of the preceding claims wherein said cover layer (24) has a thickness of at least 10 µm, in particular between 10 and 100 µm.

9. The method of any of the preceding claims wherein at least two ports (20, 21) are formed in said cover layer (24) for providing access to opposite sides of said membrane (11).

10. The method of claim 9 wherein a first one of said ports (20, 21) is connected to the connecting duct (29) of said connecting member (28) while a second one of said ports (20, 21) is connected to a chamber (39) in said housing (36), and in particular wherein said chamber (39) has an exit opening (45) arranged at a side of said housing (36) opposite to said ports (20, 21).

11. The method of any of the preceding claims further comprising the step of applying an intermediary layer (18) between at least part of said topmost dielectric layer (9) and said cover layer (24), and in particular wherein said intermediary layer (18) forms at least part of said membrane (11).

12. The method of claim 11 comprising the step of forming a channel (16) below said intermediary layer (18), wherein said channel connects said port (21) or one of said ports to a bottom side of said membrane (11) .

13. The method of any of the claims 11 to 12 wherein all of said cover layer (24) is arranged over said intermediary layer (18).

14. The method of any of the claims 11 to 13 wherein said intermediary layer (18) is a silicon layer, and in particular wherein said intermediary layer is formed by applying an SOI-wafer to said semiconductor chip (1) and structuring said SOI-wafer.

15. The method of any of the preceding claims comprising the step of compressing said semiconductor chip (1) with said cover layer (24) between said connecting member (28) and a backrest section (40) of said housing (36), thereby pushing said connecting member (28) against said cover layer (24).

16. The method of any of the preceding claims wherein said connecting member (28) is pushed against said cover layer (24) to abut against said cover layer (24) .

17. The method of any of the preceding claims wherein said connecting member (28) is glued to said cover layer (24).

18. The method of any of the preceding claims wherein said housing (36) comprises a bottom section (37) and a top section (38) as well as an auxiliary member (47), wherein said auxiliary member (37) forms said connecting member (28) and is arranged at a distance from said top section (38), and in particular wherein said top section comprises a flange (46) for attachment to an external system.

19. The method of claim 18 wherein said auxiliary member (47) is mounted to said bottom section (37) by means of a resilient glue (49).

20. The method of claim 18 wherein said auxiliary member (47) comprises an elastic lid (47a) and a sealing member (47b), wherein the sealing member (47b) is softer that the elastic lid (47a), and wherein the elastic lid (47a) is biased to push said sealing member (47b) against said port (20).

21. The method of any of the preceding claims comprising the step of forming said connecting member (28) prior to bringing it in contact with said cover layer (24).

## Patentansprüche

1. Ein Verfahren zur Herstellung eines Drucksensors umfassend
Bereitstellen eines Halbleiterchips (1) zum Tragen einer druckempfindlichen Membran (11) der eine oberste dielektrische Schicht (9) aus Siliziumoxid und/oder Siliziumnitrid hat,
**gekennzeichnet durch** die Schritte
Aufbringen einer Deckschicht (24) über der obersten dielektrischen Schicht (9), wobei die Deckschicht (24) ein Material umfasst, das verschieden von der obersten dielektrischen Schicht (9) ist und mindestens eine Öffnung (20) bildet, die Zugang zur Membran (11) zur Verfügung stellt,
Einbringen des Chips mit der Deckschicht (24) in ein Gehäuse (36) mit einem Verbindungsglied (28), wobei das Verbindungsglied (28) einen Verbindungskanal (29) bildet und
Bilden einer abgedichteten Verbindung zwischen dem Verbindungskanal (29) und der Öffnung (20).

2. Das Verfahren nach Anspruch 1, wobei die Deckschicht (24) weicher als die oberste dielektrische Schicht (9) ist.

3. Das Verfahren nach einem der vorangehenden Ansprüche, wobei die Deckschicht (24) aus einem Polymer, insbesondere einem Silikon oder Fotolack, ist.

4. Das Verfahren nach Anspruch 1, wobei die Deckschicht (24) eine Silikonschicht umfasst, und insbesondere wobei das Verfahren weiter den Schritt der Herstellung der Deckschicht (24) durch Aufbringen eines SOI-Wafer auf den Halbleiterchip (1) und Strukturieren des SOI-Wafers umfasst.

5. Das Verfahren nach einem der vorangehenden Ansprüche, umfassend den Schritt der Strukturierung der Deckschicht (24) nach dem Aufbringen der Deckschicht (24) .

6. Das Verfahren nach einem der vorangehenden Ansprüche, wobei die Deckschicht (24) eine erste Unterschicht (24a) und eine zweite Unterschicht (24b) umfasst und das Verfahren die Schritte umfasst
Aufbringen der ersten Unterschicht (24a) und Strukturieren der ersten Unterschicht (24a) mit einem ersten Muster und
Aufbringen der zweiten Unterschicht (24b) über die erste Unterschicht (24a) und Strukturieren der zweiten Unterschicht (24b) mit einem zweiten Muster, das verschieden vom ersten Muster ist, derart, dass die Öffnung (20) mit einem Kanalbereich (35) verbunden ist, der parallel zu einer Oberfläche des Halbleiterchips (1) in der ersten Unterschicht (24a) ist.

7. Das Verfahren nach einem der vorangehenden Ansprüche, umfassend den Schritt der Verwendung des Fotolacks zur Bildung der Deckschicht (24), insbesondere durch Verwendung mindestens einer Trockenfotolackschicht zur Bildung der Deckschicht (24).

8. Das Verfahren nach einem der vorangehenden Ansprüche, wobei die Deckschicht (24) eine Dicke von mindestens 10 µm, insbesondere zwischen 10 und 100 µm, hat.

9. Das Verfahren nach einem der vorangehenden Ansprüche, wobei mindestens zwei Öffnungen (20, 21) in der Deckschicht (24) gebildet werden, um Zugang zu entgegengesetzten Seiten der Membran (11) bereitzustellen.

10. Das Verfahren nach Anspruch 9, wobei eine erste der zwei Öffnungen (20, 21) mit dem Verbindungskanal (29) des Verbindungsglieds (28) verbunden ist, während eine zweite der zwei Öffnungen (20, 21) mit einer Kammer (39) im Gehäuse (36) verbunden ist, und insbesondere wobei die Kammer (39) eine Austrittsöffnung (45) hat, die an einer Seite des Gehäuses (36), die den Öffnungen (20, 21) gegenüberliegt, angeordnet ist.

11. Das Verfahren nach einem der vorangehenden Ansprüche, weiter umfassend den Schritt des Aufbringens einer Zwischenschicht (18) zwischen mindestens einem Teil der obersten dielektrischen Schicht (9) und der Deckschicht (24), und insbesondere wobei die Zwischenschicht (18) mindestens ein Teil der Membran (11) bildet.

12. Das Verfahren nach Anspruch 11, umfassend den Schritt des Bildung eines Kanals (16) unter der Zwischenschicht (18), wobei der Kanal die Öffnung (21) oder eine der Öffnungen mit einer Bodenseite der Membran (11) verbindet.

13. Das Verfahren nach einem der Ansprüche 11 bis 12, wobei die gesamte Deckschicht (24) über der Zwischenschicht (18) angeordnet ist.

14. Das Verfahren nach einem der Ansprüche 11 bis 13, wobei die Zwischenschicht (18) eine Silikonschicht ist, und insbesondere wobei die Zwischenschicht durch Aufbringen eines SOI-Wafers auf dem Halbleiterchip (1) und Strukturieren des SOI-Wafers gebildet wird.

15. Das Verfahren nach einem der vorangehenden Ansprüche, umfassend die Schritte der Komprimierung des Halbleiterchips (1) mit der Deckschicht (24) zwischen dem Verbindungsglied (28) und einem Rückenbereich (40) des Gehäuses (36), wodurch das Verbindungsglied (28) gegen die Deckschicht (24) drückt.

16. Das Verfahren nach einem der vorangehenden Ansprüche, wobei das Verbindungsglied (28) gegen die Deckschicht (24) gedrückt wird, um an der Deckschicht (24) anzustossen.

17. Das Verfahren nach einem der vorangehenden Ansprüche, wobei das Verbindungsglied (28) an die Deckschicht (24) geklebt wird.

18. Das Verfahren nach einem der vorangehenden Ansprüche, wobei das Gehäuse (36) einen Bodenbereich (37) und einen oberen Bereich (38) umfasst, sowie ein Zwischenglied (47), wobei das Zwischenglied (37) das Verbindungsglied (28) bildet und beabstandet vom oberen Bereich (38) angeordnet ist, und insbesondere wobei der obere Bereich einen Flansch (46) zur Befestigung an einem externen System umfasst.

19. Das Verfahren nach Anspruch 18, wobei das Zwischenglied (47) an der Bodenschicht (37) mittels eines elastischen Klebers (49) befestigt wird.

20. Das Verfahren nach Anspruch 18, wobei das Verbindungsglied (47) einen elastischen Deckel (47a) und ein Dichtungsglied (47b) umfasst, wobei das Dichtungsglied (47b) weicher als der elastische Deckel (47a) ist, und wobei der elastische Deckel (47a) dazu neigt, das Dichtungsglied (47b) gegen die Öffnung (20) zu drücken.

21. Das Verfahren nach einem der vorangehenden Ansprüche, umfassend den Schritt der Bildung des Verbindungsglieds (28) bevor es in Kontakt mit der Deckschicht (24) gebracht wird.

## Revendications

1. Un procédé de fabrication d'un capteur de pression comprenant
prévoir une puce semi-conductrice (1) pour porter une membrane (11) sensible à la pression et ayant une couche diélectrique supérieure (9) en oxyde de silicium et/ou nitrure de silicium,
**caractérisé par** les étapes
d'appliquer une couche de couverture (24) au-dessus de ladite couche diélectrique supérieure (9), ladite couche de couverture (24) comprenant un matériau différent de ladite couche diélectrique supérieure (9) et formant au moins une ouverture (20) qui donne accès à ladite membrane (11),
de monter ladite puce avec ladite couche de couverture (24) dans une carcasse (36) ayant un membre de connexion (28), ledit membre de connexion (28) formant un canal de connexion (29) et
de former une connexion étanche entre ledit canal de connexion (29) et ladite ouverture (20).

2. Le procédé selon la revendication 1, ladite couche de couverture (24) étant plus douce que ladite couche diélectrique supérieure (9).

3. Le procédé selon l'une des revendications précédentes, ladite couche de couverture (24) étant en un polymère, particulièrement une silicone ou une photorésine.

4. Le procédé selon la revendication 1, ladite couche de couverture (24) comprenant une couche de silicone, et particulièrement ledit procédé comprenant en outre l'étape de fabrication de ladite couche de couverture (24) en appliquant un substrat SOI à ladite puce semi-conductrice (1) et en structurant ledit substrat SOI.

5. Le procédé selon l'une des revendications précédentes, comprenant l'étape de structurer ladite couche de couverture (24) après avoir appliqué ladite couche de couverture (24).

6. Le procédé selon l'une des revendications précédentes, ladite couche de couverture (24) comprenant une première sous-couche (24a) et une deuxième sous-couche (24b) et ledit procédé comprenant les étapes
d'appliquer la première sous-couche (24a) et de structurer la première sous-couche (24a) avec un premier motif et
d'appliquer la deuxième sous-couche (24b) au-dessus de ladite première sous-couche (24a) et de structurer la deuxième sous-couche (24b) avec un deuxième motif qui est différent du premier motif, de sorte que ladite ouverture (20) soit connectée avec une section de canal (35) parallèle à une surface de ladite puce semi-conductrice (1) dans ladite première sous-couche (24a).

7. Le procédé selon l'une des revendications précédentes, comprenant l'étape d'utiliser de la photorésine pour former ladite couche de couverture (24), particulièrement en utilisant au moins une couche de photorésine sèche afin de former ladite couche de couverture (24).

8. Le procédé selon l'une des revendications précédentes, ladite couche de couverture (24) ayant une épaisseur d'au moins 10 µm, particulièrement comprise entre 10 et 100 µm.

9. Le procédé selon l'une des revendications précédentes, au moins deux ouvertures (20, 21) étant formées dans ladite couche de couverture (24) pour donner d'accès à des côtés opposés de la membrane (11).

10. Le procédé selon la revendication 9, une première des deux ouvertures (20, 21) étant connectée avec le canal de connexion (29) dudit membre de connexion (28) alors qu'une deuxième des deux ouvertures (20, 21) est connectée à une chambre (39) dans ladite carcasse (36), et particulièrement ladite chambre (39) ayant une ouverture de sortie (45) arrangée d'un côté de ladite carcasse (36) qui est opposé à lesdites ouvertures (20, 21) .

11. Le procédé selon l'une des revendications précédentes, comprenant en outre l'étape d'appliquer une couche intermédiaire (18) entre au moins une partie de ladite couche diélectrique supérieure (9) et ladite couche de couverture (24), et particulièrement ladite couche intermédiaire (18) formant au moins une partie de ladite membrane (11).

12. Le procédé selon la revendication 11, comprenant l'étape de former un canal (16) au-dessous de ladite couche intermédiaire (18), le canal connectant ladite ouverture (21) ou une desdites ouvertures à un côté de fond de ladite membrane (11).

13. Le procédé selon l'une des revendications 11 à 12, ladite couche de couverture (24) entière étant arrangée au-dessus de ladite couche intermédiaire (18).

14. Le procédé selon l'une des revendications 11 à 13, ladite couche intermédiaire (18) étant une couche de silicone, et particulièrement ladite couche intermédiaire étant formée en appliquant un substrat SOI à ladite puce semi-conductrice (1) et en structurant ledit substrat SOI.

15. Le procédé selon l'une des revendications précédentes, comprenant l'étape de comprimer ladite puce semi-conductrice (1) avec ladite couche de couverture (24) entre ledit membre de connexion (28) et une section d'appui (40) de ladite carcasse (36), par cela poussant ledit membre de connexion (28) contre ladite couche de couverture (24).

16. Le procédé selon l'une des revendications précédentes, ledit membre de connexion (28) étant poussé contre ladite couche de couverture (24) afin de buter contre ladite couche de couverture (24).

17. Le procédé selon l'une des revendications précédentes, ledit membre de connexion (28) étant collé à ladite couche de couverture (24).

18. Le procédé selon l'une des revendications précédentes, ladite carcasse (36) comprenant une section de fond (37) et une section supérieure (38) ainsi qu'un membre auxiliaire (47), ledit membre auxiliaire (37) formant ledit membre de connexion (28) et étant arrangé à une distance de ladite section supérieure (38), et particulièrement ladite section supérieure (38) comprenant une bride (46) pour l'attachement à un système externe.

19. Le procédé selon la revendication 18, ledit membre auxiliaire (47) étant monté sur ladite section de fond (37) à l'aide d'une colle élastique (49).

20. Le procédé selon la revendication 18, ledit membre auxiliaire (47) comprenant un couvercle élastique (47a) et un membre d'étanchéité (47b), le membre d'étanchéité (47b) étant plus doux que le couvercle élastique (47a), et le couvercle élastique (47a) ayant la tendance de pousser ledit membre d'étanchéité (47b) contre ladite ouverture (20).

21. Le procédé selon l'une des revendications précédentes, comprenant l'étape de former ledit membre de connexion (28) avant l'apporter en contact avec ladite couche de couverture (24).
